# EUROPEAN PATENT APPLICATION

(11) **EP 2 560 133 A1**
(43) Date of publication of application: **20.02.2013**
(21) Application number: 11177877.5
(22) Date of filing: 17.08.2011
(51) Int. Cl.: G06N 99/00, G11C 16/00, H01L 29/12

(54) **Quantum information processing**

(71) Applicant: Hitachi Ltd., Tokyo (JP)
(72) Inventor: Williams, David, Cambridge, Cambridgeshire CB3 0HE (GB)
(74) Representative: Piotrowicz, Pawel Jan Andrzej

(57) **Abstract**

A quantum information processing device is described. The device comprises an isolated quantum dot system (2) for defining a spin or charge qubit and a charge injector comprising a tunnel barrier (12) and first and second electrodes (14₂, 20). The charge injector is arranged to allow a charge carrier to be added to the isolated quantum dot system via the tunnel barrier in response to a voltage configuration applied to the first and second electrodes.

## Description

The present invention relates to quantum information processing.

Quantum information devices use quantum mechanical effects to store and process information in the form of quantum bits or "qubits". To operate efficiently, a quantum information device should maintain a minimum degree of coherence while information is being processed. However, coherence is destroyed by, amongst other things, thermal noise. Thus, it is usually necessary to cool a quantum computer to cryogenic temperatures so as to minimise thermal noise.

EP 1 262 911 A describes a quantum computer based on the distribution of an excess charge carrier on a pair of quantum dots. For example, if the excess charge carrier is on one dot, then the system is in a state |0〉. If the excess charge is on the other dot, then the system is in a state |1〉. The quantum dots are arranged in series in a channel between a source and drain, herein referred to as the "leads". Each quantum dot is separated from one of the leads and from the other quantum dot by respective controllable tunnel barriers. Using Coulomb blockade and the controllable tunnel barriers, a charge carrier can be selectively introduced from a lead onto one of the quantum dots, thus preparing the system in a given state, for example |0〉. Thereafter, the quantum dots can be electrically isolated from the leads, but allowed to interact with each other for a given duration of time during which the initial state is transformed into a superposition of |0〉 and |1〉 states. The final state of the system can be read by measuring charge on one or the other quantum dot.

A drawback of this type of quantum computer is that the leads are directly connected to cables and equipment, which are at room temperature, i.e. at around 290 K. Thus, the leads provide significant sources of noise which are directly coupled to the quantum dots and thus cause errors during operation of the quantum computer.

A solution to this problem is to remove direct coupling of the quantum dots from their leads and to carry out operations only through capacitive coupling as described in "Isolated double quantum dot capacitively coupled to a single quantum dot single-electron transistor in silicon" by E. G. Emiroglu, D. G. Hasko and D. A. Williams, Applied Physics Letters, volume 83, page 3942 (2003).

Such an isolated double quantum dot can be used to provide a charge qubit which can be initialized and manipulated using capacitively-coupled gates and measured using a capacitively coupled single-electron transistor, as described in "Charge-Qubit Operation of an Isolated Double Quantum Dot", J. Gorman, D. G. Hasko and D. A. Williams, Physical Review Letters, volume 95, page 090502 (2005).

EP 2 075 745 A describes providing an isolated conductive element between an isolated quantum dot system and an electrometer for coupling the isolated quantum dot system and the electrometer. This can help to reduce further noise and, thus, maintain coherence in the isolated double quantum dot system for longer and/or can be used for additional quantum information processing.

According to a first aspect of the present invention there is provided a quantum information processing device comprising an isolated quantum dot system for defining a qubit and a charge injector comprising a tunnel barrier and first and second electrodes, the charge injector arranged to allow charge carrier(s) to be added to the isolated quantum dot system via the tunnel barrier in response to a voltage configuration applied to the first and second electrodes.

Thus, the charge injector can be used to add (or remove) charge carrier(s) from the isolated quantum dot system and, thus, trim the device so that it has a desired number of charge carriers ready for quantum information processing.

The qubit may be a charge qubit. The qubit may be a spin qubit. The qubit may be an energy qubit.

The isolated quantum dot system may be an isolated double quantum dot system. The isolated quantum dot system may be bilobate having first and second lobes.

The device may further comprise at least one gate electrode configured to control charge distribution in the isolated quantum dot system. The device may comprise one, two, three or more gate electrodes. The gate electrode may take the form of side gates.

The device may further comprise at least one electrometer, for example in the form of a single-electron transistor, configured to detect a state of the isolated quantum dot system or a system capacitively coupled to the isolated quantum dot system.

The charge injector may comprise a channel, wherein the tunnel barrier is disposed between the channel and the isolated quantum dot system, wherein the channel is provided with first and second contact regions, one of the contact regions providing the first electrode. Thus, the device can take the form of Flash memory-like device.

The second electrode may comprise a gate electrode separated from the isolated quantum dot system by a gate dielectric and wherein at least part of the isolated quantum dot system (for example, one of the lobes) is interposed between the gate electrode and the tunnel barrier.

The isolated quantum dot system may comprise a semiconducting material, such as silicon. The isolated quantum dot system may comprise a monocrystalline semiconducting material or a poly crystalline semiconducting material.

The device may further comprise a magnetic field source, such as a loop, coil or wire, configured to apply a magnetic field to the isolated quantum dot system. Preferably, the magnetic field source applies the magnetic field locally to the isolated quantum dot system, in other words, the magnetic field source applies the magnetic field to the isolated quantum dot system to the exclusion of any other isolated quantum dot system, if present.

The device may comprise an array of isolated quantum dot systems. The array may include two or more isolated quantum dot systems.

According to a second aspect of the present invention there is provided apparatus comprising at least one quantum information processing device, a radio frequency signal source; and an antenna coupled to the source, the source and antenna arranged to excite the isolated quantum dot system or, if more than one isolated quantum dot system, at least one of the isolated quantum dot systems.

According to a third aspect of the present invention there is provided a method of operating a quantum information processing device comprising an isolated quantum dot system, the method comprising injecting a charge carrier into the isolated quantum dot system, preparing an initial state of a qubit defined by the isolated quantum dot system, transforming the initial state and reading out a final state.

The quantum information processing device may comprise at least two isolated quantum dot systems and the method may comprise preparing at least one of the isolated quantum dot systems as a spin qubit and preparing at least one of the isolated quantum dot systems as a charge qubit.

Certain embodiments of the present invention will now be described, by way of example, with reference to the accompanying drawings, in which:
Figure 1 is a plan view of a quantum information processing device;
Figure 1a is a cross-sectional view of the quantum information processing device shown in Figure 1 taken along the line A—A';
Figure 1b is a cross-sectional view of the quantum information processing device shown in Figure 1 taken along the line B—B';
Figure 2 is a schematic diagram of the quantum information processing device shown in Figure 1 and control and measurement circuitry and control devices;
Figure 3 is a flow diagram illustrating a method of operating the quantum information processing device shown in Figure 1;
Figure 4 illustrates injection of an electron into a quantum information processing device;
Figure 5 illustrates basis states of an isolated quantum dot system based on ground and excited states;
Figure 6 illustrates sequential injection of charge carriers into an isolated quantum dot system;
Figure 7 illustrates an array of isolated quantum dot systems;
Figure 8 is a graph showing schematic plots of electric field and magnetic field;
Figure 9 is a flow diagram illustrating a method of fabricating the quantum information processing device shown in Figure 1;
Figures 10a to 10h illustrate the device shown in Figure 1 at different stages during fabrication;
Figures 11a to 11h illustrate the device shown in Figure 1 at different stages during fabrication; and

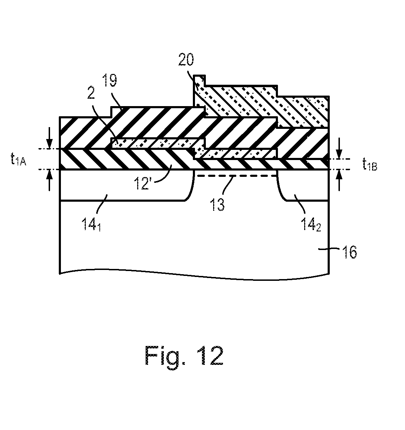

Figure 12 is a cross-sectional view of a quantum information processing device having stepped dielectric layer.

### Device layout

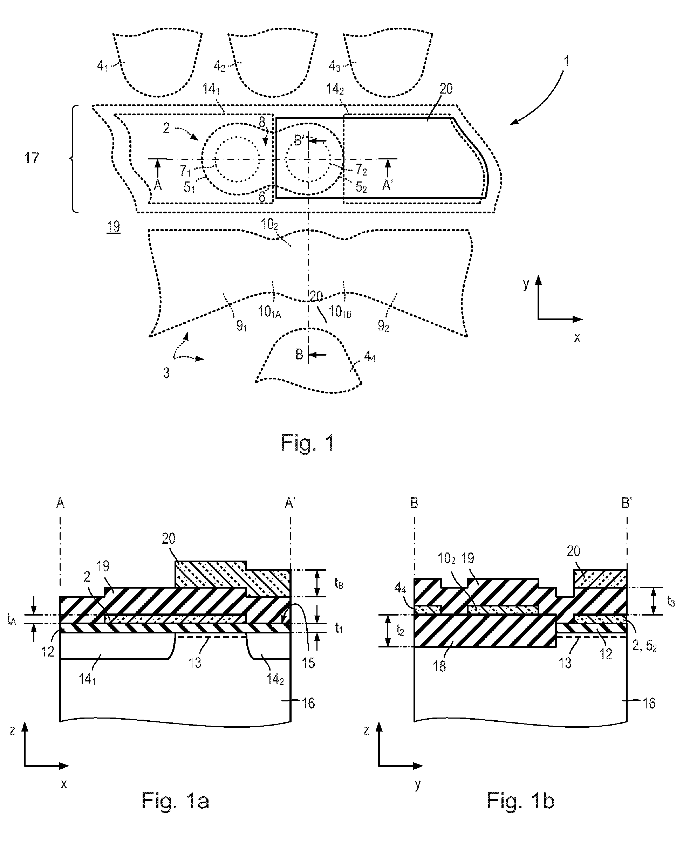

Referring to Figures 1, 1a and 1b, a quantum information processing device 1 is shown.

The quantum information processing device 1 includes an isolated double quantum dot system 2 capacitively coupled to an electrometer 3 which is in the form of a single-electron transistor. The device 1 also includes a plurality of side gates 4₁, 4₂, 4₃, 4₄ for controlling operation of the isolated quantum dot system 2 and the electrometer 3. The isolated double quantum dot system 2, electrometer 3 and side gates 4₁, 4₂, 4₃, 4₄ are similar in shape, size and configuration to those described in EP 2 075 745 A *ibid.* which is incorporated herein by reference.

The isolated double quantum dot system 2, single electron transistor 3 and side gates 4₁, 4₂, 4₃, 4₄ are generally planar, are formed from polycrystalline silicon (Si) and have a thickness typically lying in a range of about 10 to about 50 nm.

The isolated quantum dot system 2 is patterned such that it has first and second lobe regions 5₁, 5₂ and a connecting region 6. The first and second lobe regions 5₁, 5₂ define first and second quantum dots 7₁, 7₂ and the connecting region 6 forms a tunnel barrier 8 between the quantum dots 7₁, 7₂. In plan view, the first and second lobe regions 5₁, 5₂ appear as intersecting oval regions. However, other lobed arrangements, such as a dumb-bell arrangement, may be used.

The first and second lobe regions 5₁, 5₂ each have a diameter of about 40 nm. However, the first and second lobe regions 5₁, 5₂ may have a diameter between 20 and 70 nm. The width and length of the connecting region 6 are about 20 nm. Thus, the isolated quantum dot system 2 is about 40 nm wide and about 100 nm long.

The dimensions of the lobe and connecting regions 5₁, 5₂, 6 may be the order of 1 nm, 10 nm or even 100 nm. Computer simulation can be used and/or routine experiments may be conducted to determine the dimensions of the regions 5₁, 5₂, 9. Generally, larger lobe regions 5₁, 5₂ provide more closely-spaced quantum energy levels and charging energy levels and, thus, the operating temperature of the device becomes lower. Routine experiments may also be conducted to determine the dimensions of the connecting region 6. Generally, narrower and/or longer the connecting region 6 provide(s) a higher barrier resistance. The connecting region 6 is usually arranged such that its resistance exceeds the quantum resistance R_{K} but is not so high that tunnelling between the quantum dots 7₁, 7₂ becomes difficult even at high electric fields. The width and length of the connecting region 6 need not be equal.

The single-electron transistor 3 comprises source and drain regions 9₁, 9₂ and a channel region 10_{1A}, 10_{1B}, 10₂. In plan view, the source and drain regions 9₁, 9₂ are initially splayed, being narrower close to the channel 10_{1A}, 10_{1B}, 10₂ and becoming wider further away from the channel. The channel 10_{1A}, 10_{1B}, 10₂ is laterally "pinched" so as to produce first and second narrow channel portions 10_{1A}, 10_{1B} and an intermediate wide channel portion 10₂. Other channel arrangements may be used. For example, the channel may be arranged as a so-called "nanowire" having substantially uniform width along its length.

The single-electron transistor 3 is arranged such that a third quantum dot (not shown) is formed in the conductive region wide channel portion 10₂ and first and second tunnel barriers (not shown) are formed in the first and second narrow channel portions 10_{1A}, 10_{1B} respectively. The quantum dot (not shown) is configured such that it exhibits charging effects, i.e. Coulomb blockade. The single-electron transistor 3 may be arranged, for example, using a nanowire, such that plural quantum dots (not shown) and plural tunnel barriers (not shown) are defined, which are formed alternately along the channel.

The wide channel portion 10₂ has a width and length of about 40 nm. The width and length of the narrow channel portions 10_{1A}, 10_{1B} are about 20 nm. However, the widths and lengths need not be equal. The dimensions of the narrow and wide channel regions 10_{1A}, 10_{1B}, 10₂ may be the order of 1 nm, 10 nm or even 100 nm. Routine experiments may be used to determine the dimensions of the channel 10_{1A}, 10_{1B}, 10₂.

The single-electron transistor 3 is arranged along one side of the isolated dot system 2 such that the wide channel portion 10 is closer to the second lobe region 5₂ than it is to the first lobe region 5₁ or *vice versa.* Thus, the single electron transistor 3 may be used to detect polarization of the isolated dot system 2. The wider channel portion 10₂ and the second lobe region 5₂ are separated by about 80 nm.

A second single electron transistor (not shown) may be provided. If two single electron transistors are provided, one transistor can be configured to detect charge in one lobe region 5₁ and the other transistor can be configured to detect charge in the other lobe region 5₂.

First, second and third finger-like side gates 4₁, 4₂, 4₃ are arranged in a row along one side of the isolated quantum dot system 2. The second side gate 4₂ is arranged to be substantially equidistant from the first and second lobes 5₁, 5₂. The first and third side gates 4₁, 4₃ are arranged on either side of the second side gate 4₂ and arranged to be closer to the first and second lobes 5₁, 5₂ respectively.

The gates 4₁, 4₂, 4₃ are arranged such that the second gate 4₂ can be used to control coupling between the first and second quantum dots 7₁, 7₂, while the first and third side gates 4₁, 4₃ may be used to apply an electric field, E, so as to polarise the isolated dot system 2. Thus, the first, second and third side gates 4₁, 4₂, 4₃ may be arranged differently to achieve or contribute towards these functions. The gates 4₁, 4₂, 4₃ and the isolated quantum dot system 2 are separated by about 40 nm (along the y-axis).

Fourth side gate 4₄ is arranged alongside the wide channel portion 10₂ of the single electron transistor 3 on the far side from the isolated dot system 2.

The gate 4₄ is arranged to induce charge on a quantum dot (not shown) of the single-electron transistor 3 and thus control current flow. Thus, the wide channel portion 10₂ is disposed between the second lobe 5₂ of the isolated dot system 2 and the fourth side gate 4₄. Thus, the fourth gate 4₄ may be arranged differently to achieve or contribute towards this function. The gate 4₄ and the wider channel portion 10₂ are separated by about 40 nm.

The isolated quantum dot system 2, single-electron transistor 3 and side gates 4₁, 4₂, 4₃, 4₄ are doped with phosphorous (P) to a concentration of 2.9×10¹⁹_{cm}⁻³ . The isolated quantum dot system 2, single-electron transistor 3 and side gates can be doped to a lower concentration or can be undoped, for example, having a background impurity concentration of less than or equal to about 10¹⁵_{cm}⁻³.

The isolated quantum dot system 2 is provided with a charge injector which can be used to inject (or remove) charge carriers into the isolated quantum dot system 2.

The charge injector includes a first, thin dielectric layer 12 formed directly on a channel 13 which runs between first and second contact regions 14₁, 14₂ (herein also referred to as source and drain regions) and which are formed at a top surface 15 of a semiconductor substrate 16. In this example, the semiconductor substrate is p-type and the contact regions 14₁, 14₂ are n-type.

The isolated quantum dot system 2 is formed directly on the first dielectric layer 12 and is arranged such that the first lobe 5₁ overlies the first contact region 14₁ and the second lobe 5₂ overlies lies the channel 13.

The isolated quantum dot system 2 and thin dielectric layer 12 are disposed in an elongate window 17 formed in a second, thick dielectric layer 18. The single-electron transistor 3 and side gates 4₁, 4₂, 4₃, 4₄ are formed on either side of the window 17 on the second, thick dielectric layer 18. This arrangement can help minimise leakage to the substrate 16.

The charge injector also includes a third, thick dielectric layer 19 which overlies the isolated quantum dot system 2 and the first and second dielectric layers 12, 18. The charge injector further includes a control electrode 20 disposed on the thick dielectric layer 19. The control electrode 20 runs over the second lobe 5₂, but not the first lobe 5₁ of the isolated quantum dot system 2. As will be described later in more detail, this arrangement allows charge carriers to be injected into the second lobe 5₂ in preference to the first lobe 5₁.

The second lobe 5₂ of the isolated quantum dot system 2 is sandwiched between the channel 13 and the control electrode 20 separated by the first and third dielectric layers 12, 19 respectively. The first dielectric layer 12 is sufficiently thin to provide a tunnel barrier and the third dielectric layer 19 is sufficiently thick so as to provide an insulating layer though which charge carriers cannot tunnel.

The first dielectric layer 12 is formed silicon dioxide (SiO₂) and has a thickness, t₁, having a value typically lying in a range of between about 3 and 5 nm. However, other dielectric materials such as silicon nitride or silicon oxynitride may be used. The second dielectric layer 18 is formed from silicon dioxide (SiO₂) and has a thickness, t₂, having a value typically of about 1 µm. The third dielectric layer 19 is formed from silicon dioxide (SiO₂) and has a thickness, t₃, having a value typically lying in a range of between about 20 and 50 nm.

The third dielectric layer 19 provides a non-tunnelling dielectric. Thus, there is only one path onto the isolated quantum dot system 2, i.e. via the first dielectric layer 12.

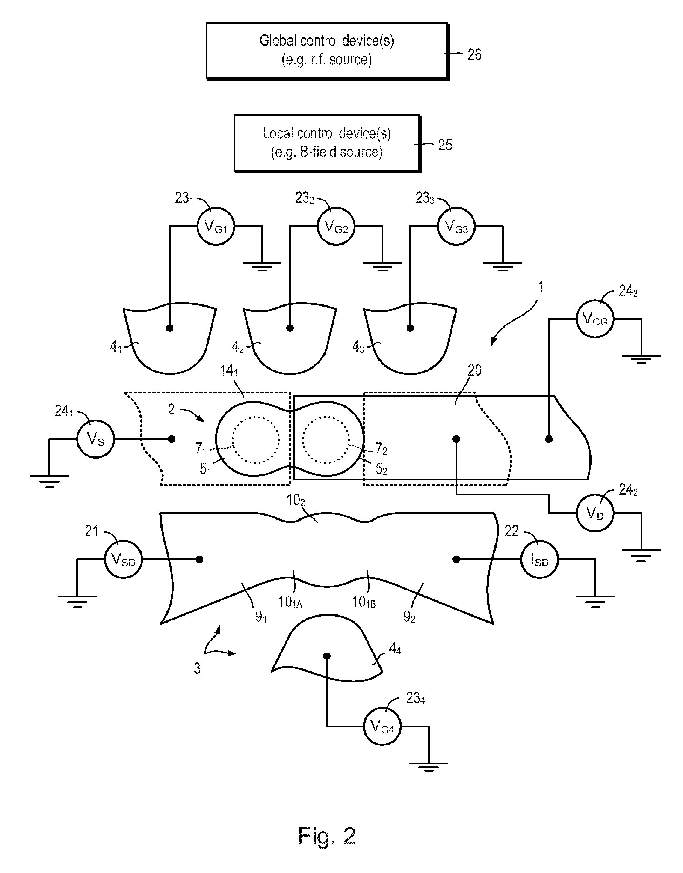

Figure 2 shows control and measurement circuits and devices for the quantum information processing device 1. In Figure 2, the third dielectric layer 19 is not shown for clarity.

A first voltage source 21 is used to apply a bias V_{SD} between source and drain 9₁, 9₂ of the single-electron transistor 3. A current meter 22 is used to measure current flowing through the transistor 3 and, thus, detect charge in the second quantum dot 7₂.

Second, third, fourth and fifth voltage sources 23₁, 23₂, 23₃, 23₄ are used to apply a gate biases V_{G1}, V_{G2,} V_{G3,} V_{G4} to the first, second, third and fourth gates 4₁, 4₂, 4₃, 4₄ respectively. As will be explained later, the second, third, fourth and fifth voltage sources 23₁, 23₂, 23₃, 23₄ can be used to initialise and manipulate a qubit.

Sixth, seventh and eighth voltage sources 24₁, 24₂, 24₃ are used to apply biases to the first contact region 14₁, second contact region 14₂ and the control gate 20 respectively of the charge injector. The sixth, seventh and eighth voltage sources 24₁, 24₂, 24₃ are used to inject (or remove) one or more charge carriers from the isolated quantum dot system 2.

The quantum information processing device 1 may include further on-chip and off-chip control devices.

The quantum information processing device 1 may include one or more local control devices 25. In particular, a conducting loop, coil or wire or sets of loop, coils or wires can be used to generate a magnetic field in the vicinity of the isolated quantum dot system 2. The loop(s), coil(s) or wire(s) may be provided using tracks of metallic or highly-doped semiconductor material separated from other conducting parts of the device by a dielectric layer (not shown). Each local control device 25 is connected to an external signal source (not shown) which can be used to control the magnitude and duration of the applied magnetic field.

If there is more than one isolated quantum dot system 2, then respective one or more of such local control device 25 can be provided for each isolated quantum dot system 2. Each local control devices 25 is preferably arranged so that it controls or influences only one quantum dot system 2 thereby allowing individual control of quantum dot systems 2.

The quantum information processing device 1 may include one or more global control devices 26. In particular, an antenna connected to a high-frequency signal source (not shown) can be used to apply an r.f. signal to the isolated quantum dot system 2 or, if there is more than one quantum dot system 2, to more than one or all of the quantum dot systems 2.

The quantum information processing device 1 is cooled to below 4.2 K (preferably below 100 mK) using a refrigerator (not shown).

The as-fabricated isolated quantum dot system 2 may possess no excess charge carriers (e.g. electrons) or may possess too many excess charge carriers to form a well-defined and/or controllable two-state system based on spin or charge. However, the charge injector can be used to inject or remove charge from the isolated quantum dot system 2 so as to provide a single excess charge carrier or other number of excess charge carriers.

### Operation

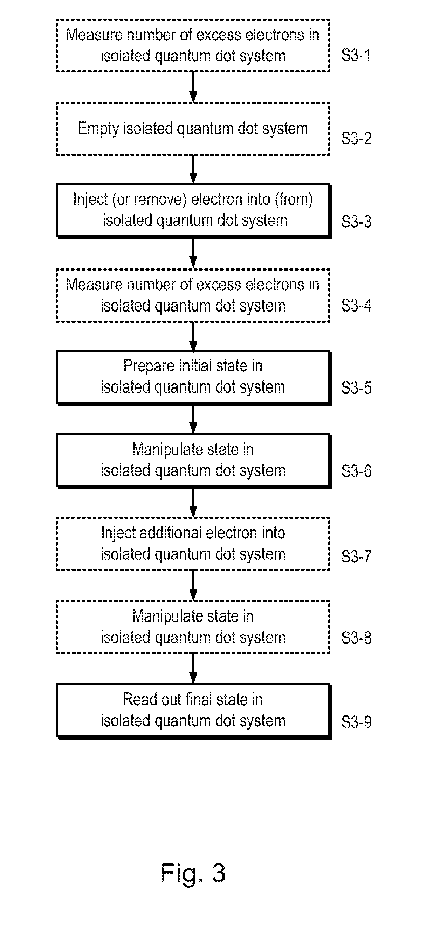

Referring to Figures 2, 3 and 4, a method of operating the quantum information processing device 1 will now be described.

The electrometer 3 and gates 4₁, 4₂, 4₃, 4₄ can be used to determine the number of excess charge carriers contained in the fabricated isolated quantum dot system 2 (step S3-1). For example, by sweeping gate biases and measuring current, a stability diagram can plotted which can be inspected to identify the number of electrons present on the isolated quantum dot system 2.

Additionally or alternatively, the isolated quantum dot system 2 can be emptied of excess charge carriers, if any are present, by applying, for example a large negative bias, V_{CG}, to the control electrode 20 and a large positive bias, V_{D}, to the second contact region 14₂ (step S3-2). A large positive bias, Vₛ, can also be applied to the first contact region 14₂. Suitable values of biases can be found by experiment. However, typically, V_{CG} < —5V and (Vₛ =)V_{D} >+5V.

The number of excess electrons in the isolated quantum dot system 2 can be varied (step S3-3).

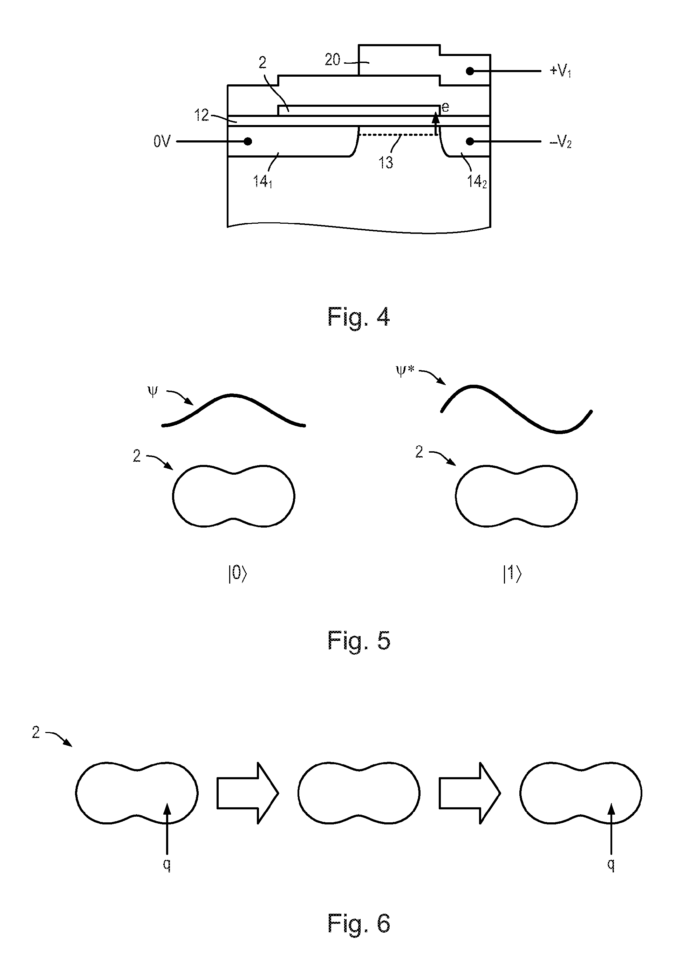

The number of excess electrons can be increased by applying a large positive bias V_{CG} = +V₁ to the control electrode 20 and a large negative bias, V_{S} = -V₂ to the second contact region 14₂, while the first contact region 14₁ is tied to ground, is left to float or a small negative bias is applied. Suitable values can be found by experiment. However, typically, V_{CG} > +5V and V_{D} < -5V. As shown in Figure 4, an electron, e, tunnels from the channel 13 close to the second contact region 14₂ through the first dielectric layer 12 and into the isolated quantum dot system 2. The injection process is typically self-limited by Coulomb blockade. A combination of biases can be applied which are of sufficiently small magnitude to cause injection of only one electron. Once a single electron has been injected into the isolated quantum dot system 2, injection of further electrons is prevented due to Coulomb blockade. Unless biases having larger magnitudes are applied which overcome Coulomb blockade of the next electron, no further electrons are injected.

The biases can be applied to control electrode 20 and the second contact region 14₂ in the form of pulses having durations ΔT_{CG} and Δt_{D} respectively which overlap for a period, Δt_{prog}, where min(Δt_{CG}, Δt_{D}) ≥ Δt_{prog} > 0. The programming period may be a few nanoseconds.

Pulse duration can be used to control stochastically the number of excess electrons injected in cases where Coulomb blockade or some other form of correlated tunnelling effect is not used.

The electrometer 3 and gates 4₁, 4₂, 4₃ can be used to confirm the number of excess charge carriers contained in the isolated quantum dot system 2. This step may be necessary if a stochastic tunnelling process is used.

With a single excess charge (for example, an electron), the isolated quantum dot system 2 can be used to form a charge qubit having basis states, for example:
|0〉 = |excess charge on the first quantum dot 7₁〉
|1〉 ≡ |excess charge on the second quantum dot 7₂〉

Referring to Figure 5, with a single excess charge, the isolated quantum dot system 2 can be used to form an energy qubit having basis states, for instance:
|0〉 ≡ |ground state〉
|1〉 ≡ |excited state〉

With a single excess charge (for example, in a ground state), the isolated quantum dot system 2 can also be used to form a spin qubit having basis states, for example:
|0〉 ≡ |↑〉
|1〉 ≡ |↑〉

For spin and energy qubits, the qubit is preferably prepared and manipulated without any charge re-distribution, i.e. between lobe regions 5₁, 5₂. Thus, there is no change in electric dipole moment and, thus, no interaction between qubits through electric dipole moments.

An initial state, for example |Ψᵢ〉 = |0〉, is prepared (step S3-5).

In the case of the charge qubit, the initial state |Ψᵢ〉 can be prepared by applying appropriate biases to the first, second and third gates 4₁, 4₂, 4₃. In the case of the energy qubit, the initial state |Ψᵢ〉 can also be prepared by applying appropriate biases to the first, second and third gates 4₁, 4₂, 4₃. In the case of a spin qubit, the initial state |Ψᵢ〉 can be prepared by applying appropriate biases to the first, second and third gates 4₁, 4₂, 4₃ and by applying a magnetic field using a local control device 25 (Figure 2).

A unitary transformation Uₜ of the initial state is performed (step S3-6).

In the case of charge qubit, this may comprise applying a pulse to the second gate 4₃ for a predetermined time, t, so as to lower the barrier height between the quantum dots 7₁, 7₂ permit charge tunnelling between the first and second quantum dots 7₁, 7₂. This transforms the initial state |Ψᵢ〉 into a final state |Ψ_{f}〉 consisting of mixture of states |0〉 and |1〉.

In the case of charge, energy or spin qubit, a unitary transformation may involve applying r.f. radiation tuned to the energy gap between two states.

Optionally, an additional excess charge may be injected into the isolated quantum dot system 2 (step S3-7).

Optionally, an additional transformation can be carried out (step S3-8).

Finally, a measurement of the final state |Ψ_{f}〉 is carried out (step S3-9).

In the case of charge qubit, measurement comprises measuring the charge on the second quantum dot 7₂ using electrometer 3.

Referring also to Figure 6, in the case of energy or spin qubit, measurement may comprise trying to inject an additional charge onto into the isolated quantum dot system 2.

For an energy qubit, if the energy of the additional charge exceeds the ground state, but not the excited state and the additional charge cannot be injected into the quantum dot system 2, then it can be inferred that the isolated quantum dot system 2 is in the |1〉 state.

For a spin qubit, if the spin of the additional charge is, for example, ↑ and the additional charge cannot be injected (due to Pauli exclusion) then it can be inferred that the isolated quantum dot system 2 is in the |1〉.

Whether or not additional charge has been injected can be determined by measuring the charge on the second quantum dot 7₂ using electrometer 3.

It will be appreciated that other methods of measuring charge, energy and spin qubits can be used.

A method of characterising a transformation and determining what period of time t should be used to carry out a Hadamard transformation, U_{H}, is described in EP 1 262 911 A *ibid.* which is incorporated herein by reference.

### Operation of arrays of isolated quantum dot systems

Switching between qubit types can be useful for controlling interaction between qubits.

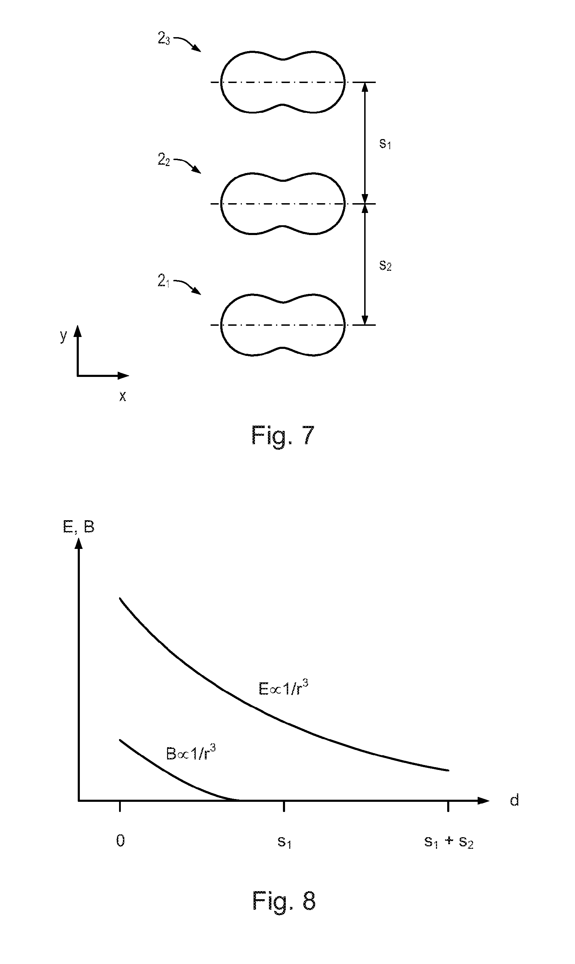

Figure 7 shows an array of isolated double quantum dot systems 2₁, 2₂, 2₃. The isolated double quantum dot systems 2₁, 2₂, 2₃ are arranged in a column (along the y-axis) and are orientated in parallel (i.e. along the x-axis). The isolated double quantum dot systems 2₁, 2₂, 2₃ are separated by distances, s₁, s₂. In this example, S₁ = S₂.

Figure 8 schematically shows a schematic plot 27 of the magnitude of magnetic field strength of a charge spin and a plot 28 of the magnitude of electric field of an electric dipole.

As shown in Figure 8, magnetic field drops off quickly whereas electric field drops off more slowly. By appropriately separating the isolated quantum dot systems, spin qubits can be prepared and manipulated independently.

Different isolated double quantum dot systems can be prepared as different types of qubits. Moreover, isolated double quantum dot system need not be prepared as a qubit.

Isolated double quantum dot systems in an array need not be the same, e.g. have the same dimensions. This can allow different quibits in an array to be addressed in individually or in groups.

### Fabrication

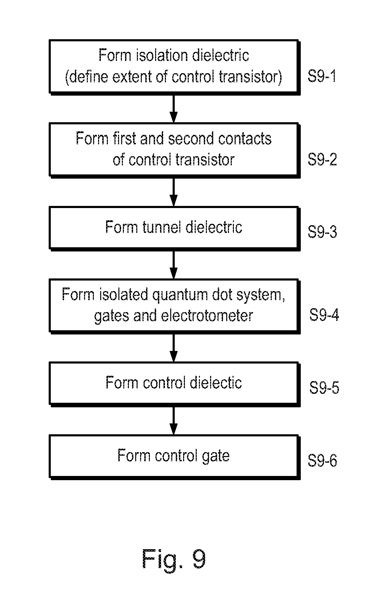

Referring to Figures 9, 10a to 10h and 11a to 11h, a method of fabricating the quantum information processing device 1 shown in Figures 1, 1a and 1b will now be described.

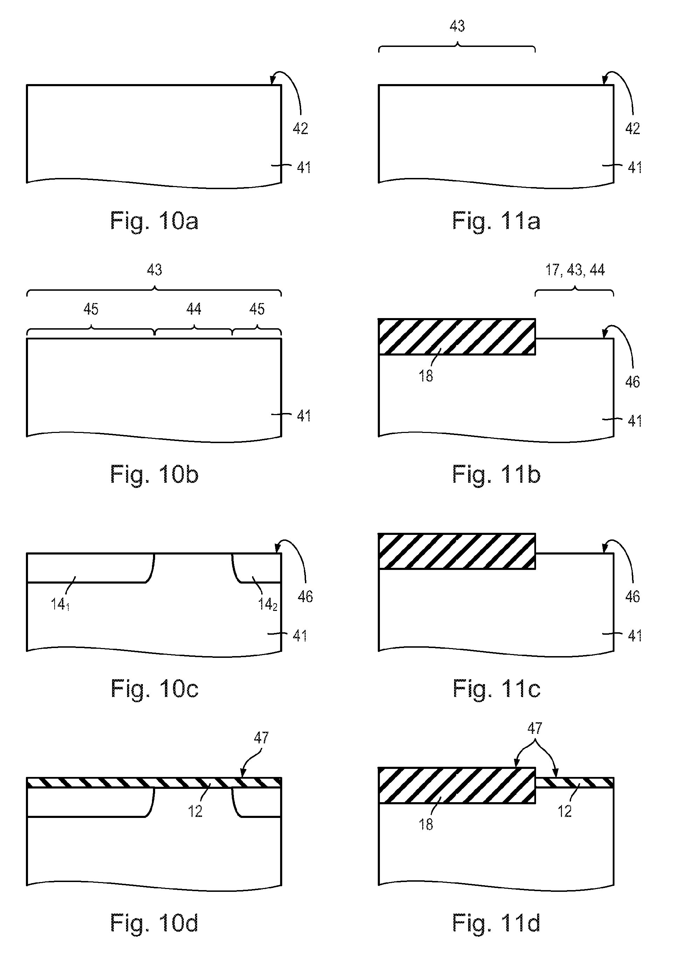

Referring in particular to Figures 10a and 11a, the device is formed on a p-type silicon wafer 41 having a top (or "principal") surface 42.

Isolation dielectric, in this case field oxide 18 (Figure 1a), is formed on the wafer 41 (step S8-1).

First portions 43 of the wafer 41 are converted into and/or covered with dielectric material to provide an insulating base on which the electrometer 3, side gates 4₁, 4₂, 4₃, 4₄ and other structures (such as bond pads) can be formed.

Referring in particular to Figures 10b and 11b, a field oxide 18 having a window 17 is formed by thermal oxidation using a LOCOS process.

Contact regions 14₁, 14₂ are formed in the wafer 41 (step S8-2).

A layer (not shown) of resist is applied over the exposed surface 43 of the wafer 41 and is patterned to form a mask (not shown). The mask (not shown) is used to protect a portion 44 of the wafer 41 from implantation. Arsenic ions are implanted into unmasked areas 45.

Referring in particular to Figures 10c and 11c, the mask (not shown) is removed and the structure is annealed to activate the implant leaving n-type contact regions 14₁, 14₂.

The tunnel dielectric layer 12 is formed on the uncovered surface 46 of the wafer 41 (step S8-3).

Referring in particular to Figures 10d and 11d, a layer 12 of silicon dioxide is grown by thermal oxidation.

The isolated quantum dot system 2, electrometer 3 and gates 4₁, 4₂, 4₃, 4₄ are then formed on the upper surfaces 47 of the dielectric layers 12, 18 (step S8-4).

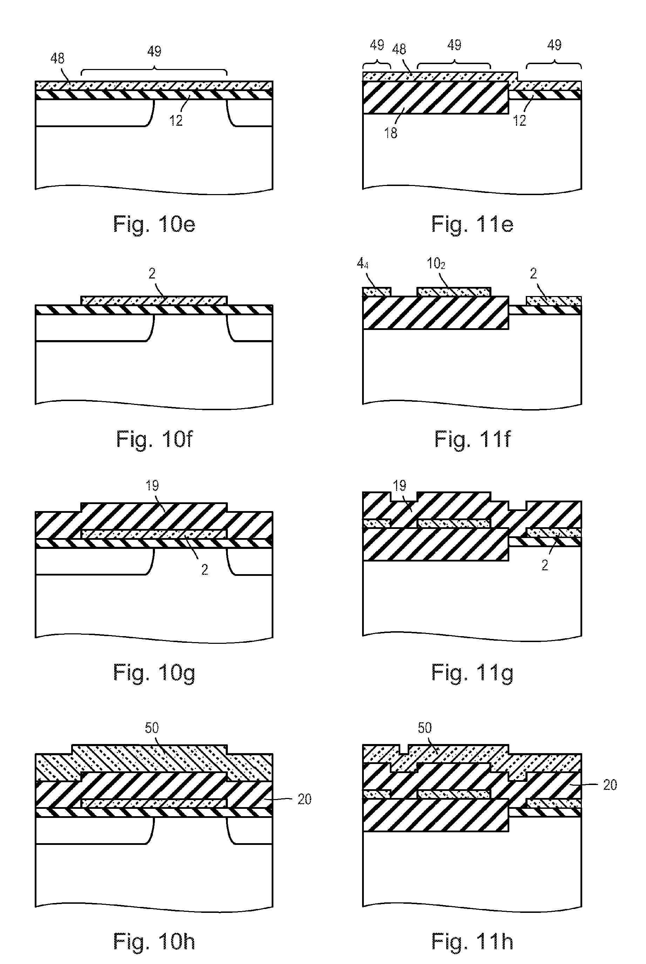

Referring in particular to Figures 10e and 11e, a layer 48 of polycrystalline silicon is grown by chemical vapour deposition (CVD) over the dielectric layers 12, 18. The polycrystalline layer 48 can be doped in-situ during growth with phosphorous or arsenic.

A layer (not shown) of photoresist is applied over the polycrystalline layer 48 and is patterned to form a mask (not shown). The mask (not shown) is used to protect portions 49 of the polycrystalline layer 48 from being etched.

The mask pattern is transferred to the underlying polycrystalline layer 48 by reactive ion etching (RIE) using suitable feed gases (not shown) and the resulting structure is shown in Figures 8f and 9f.

Referring to Figures 10f and 11f, the resulting structure includes the isolated quantum dot system 2, electrometer 3 (Figure 1) including channel portion 10₂ and gates 4₁, 4₂, 4₃, 4₄ (Figure 1) including fourth gate 4₄.

The control gate dielectric layer 19 (Figure 1a) is then formed (step S8-5).

Referring in particular to Figures 10g and 11g, a layer 19 of silicon dioxide is grown by CVD over the isolated quantum dot system 2 and other portions of the device.

The control gate 20 (Figure 1a) is then formed (step S8-6).

Referring in particular to Figures 10h and 11h, a layer 50 of polycrystalline silicon is grown by CVD over the silicon dioxide layer 19.

A layer (not shown) of photoresist is applied over the polycrystalline layer 50 and is patterned to form a mask (not shown).

The mask pattern is transferred to the underlying polycrystalline layer 50 by reactive ion etching (RIE) using suitable feed gases (not shown). The resulting structure is shown in Figures 1a and 1b.

### Modification

Referring to Figures 1a and 1b, in the quantum information processing device 1 describes earlier, a thin dielectric layer 12 having uniform thickness is used. However, charge carriers can leak from the first contact 14₁ into the first lobe 5₁.

Referring to Figure 11, leakage into the first lobe 5₁ can be minimised by using a stepped dielectric layer 12'. The dielectric layer 12' can have a thickness t_{1A} and a thickness t_{2B} under the first and second lobes 5₁, 5₂ (Figure 1) respectively, where t_{1A} > t_{1B} (=t₁). For example, 20 nm > t_{1A} > 5 nm for silicon dioxide.

The stepped profile can be achieved in any one of a number of different ways. For example, the profile can be formed by growing a thick dielectric layer having a thickness of t_{1B}, forming a mask (not shown) exposing a region over the channel etching the layer until it has a thickness t_{1A}.

The stepped dielectric layer may comprise two layers comprising different materials, for example, silicon dioxide and silicon nitride, and well defined thicknesses can be achieved by using selective etches.

It will be appreciated that many modifications may be made to the embodiments hereinbefore described.

The isolated quantum dot system 2 may be used having one quantum dot, three quantum dots or more than three quantum dots. For example, a single quantum dot can be used to define energy or spin qubit. Two or more quantum dots can be used to define two or more qubits.

More than one charge injector can be provided.

The isolated quantum dot system 2 may be asymmetric. For example one lobe region may have a diameter, d, and the other lobe region may have a greater diameter, for example, up to about 1.5d.

The isolated quantum dot system 2, single electron transistor 3 and side gates 4₁, 4₂, 4₃, 4₄ may be doped with other n-type impurities or a p-type impurity and to a concentration of the order of 10¹⁸cm⁻³, 10¹⁹cm⁻³ or 10²⁰cm-³_{.}

The isolated quantum dot system 2, single electron transistor 3 and side gates 4₁, 4₂, 4₃, 4₄ may comprise other doped semiconductor materials such as silicon-germanium (SiGe) or binary or tertiary materials, for instance gallium arsenide (GaAs). For example, the isolated quantum dot system 2, single electron transistor 3 and side gates 4₁, 4₂, 4₃, 4₄ may comprise intrinsic GaAs, n⁻ GaAs, n⁺ GaAs or δ-doped GaAs.

## Claims

**1.** A quantum information processing device comprising:
an isolated quantum dot system (2) for defining a qubit;
**characterised by:**
a charge injector comprising a tunnel barrier (12) and first and second electrodes (14₂, 20), the charge injector arranged to allow charge carrier(s) to be added to the isolated quantum dot system via the tunnel barrier in response to a voltage configuration applied to the first and second electrodes.

**2.** A device according to claim 1, wherein the isolated quantum dot system (2) is an isolated double quantum dot system.

**3.** A device according to claim 1 or 2, wherein the isolated quantum dot system (2) is bilobate having first and second lobes (5₁, 5₂).

**4.** A device according to any preceding claim, further comprising:
at least one gate electrode (4₁, 4₂, 4₃) configured to control charge distribution in the isolated quantum dot system (2).

**5.** A device according to any preceding claim, further comprising:
at least one electrometer (3) configured to detect a state of the isolated quantum dot system or a system capacitively coupled to the isolated quantum dot system.

**6.** A device according to any preceding claim, wherein the charge injector comprises:
a channel (13);
wherein the tunnel barrier (12) is disposed between the channel and the isolated quantum dot system (2), wherein the channel is provided with first and second contact regions (14₁, 14₂), one of the contact regions (14₂) providing the first electrode.

**7.** A device according to any preceding claim, wherein the second electrode (20) comprises a gate electrode separated from the isolated quantum dot system by a gate dielectric (19) and wherein at least part (5₂)of the isolated quantum dot system (2) is interposed between the gate electrode and the tunnel barrier.

**8.** A device according to any preceding claim, wherein the isolated quantum dot system (2) comprises a semiconducting material and, optionally, the semiconducting material is silicon.

**9.** A device according to any preceding claim, further comprising:
a magnetic field source (25) configured to apply a magnetic field to the isolated quantum dot system.

**11.** A device according to any preceding claim, comprising:
an array of isolated quantum dot systems (2).

**12.** Apparatus comprising:
a quantum information processing device according to any preceding claim;
a radio frequency signal source (26); and
an antenna (26) coupled to the source, the source and antenna arranged to excite the isolated quantum dot system or, if more than one isolated quantum dot system, at least one of the isolated quantum dot systems.

**13.** A method of operating a quantum information processing device comprising an isolated quantum dot system, the method comprising:
injecting a charge carrier into the isolated quantum dot system;
preparing an initial state of a qubit defined by the isolated quantum dot system;
transforming the initial state; and
reading out a final state.

**14.** A method according to claim 13, wherein the quantum information processing device comprises at least two isolated quantum dot systems, the method comprising:
preparing at least one of the isolated quantum dot systems as a spin qubit; and
preparing at least one of the isolated quantum dot systems as a charge qubit.
